# EUROPÄISCHE PATENTSCHRIFT

(11) **EP 3 436 789 B1**
(45) Veröffentlichungstag und Bekanntmachung des Hinweises auf die Patenterteilung: **12.05.2021**
(21) Anmeldenummer: 17712938.4
(22) Anmeldetag: 14.03.2017
(51) Int. Cl.: G01F 23/296

(54) **VERFAHREN ZUM HERSTELLEN EINES ULTRASCHALLSENSORS UND ULTRASCHALLSENSOR**
METHOD FOR PRODUCING AN ULTRASOUND SENSOR, AND ULTRASOUND SENSOR
PROCÉDÉ DE FABRICATION D'UN CAPTEUR À ULTRASONS ET CAPTEUR À ULTRASONS

(30) Priorität: 30.03.2016 DE 102016205240
(43) Veröffentlichungstag der Anmeldung: 06.02.2019
(73) Patentinhaber: Vitesco Technologies GmbH, 30165 Hannover (DE)
(72) Erfinder: ROTH, Manfred, 90613 Großhabersdorf (DE); PFEIFFER, Karl-Friedrich, 91058 Erlangen (DE); KONOPKA, Peter, 02313 Cierne (SK); MEZULIAN, Frantisek, 736 01 Havirov-Podlesi (CZ); SOFER, Pavel, 748 01 Hlucín (CZ)
(86) Internationale Anmeldenummer: PCT/EP2017/055991
(87) Internationale Veröffentlichungsnummer: WO 2017/167574

(56) Entgegenhaltungen:
- EP-A1- 0 853 236
- WO-A1-2013/102581
- DE-A1-102005 012 041
- DE-A1-102007 059 584
- DE-A1-102009 046 143
- DE-A1-102010 061 752
- DE-A1-102012 014 307
- US-A1- 2016 041 024

## Beschreibung

Die Erfindung betrifft ein Verfahren zum Herstellen eines Ultraschallsensors und einen Ultraschallsensor, insbesondere ein Verfahren zum Herstellen eines Ultraschallsensors zum Erfassen des Füllstands eines in einer Brennkraftmaschine verwendeten Fluides, wie beispielsweise eines Motoröls.

Ultraschallsensoren werden beispielsweise zum Erfassen des Füllstands eines Öls innerhalb einer Ölwanne einer Brennkraftmaschine verwendet. Dabei werden zur Erfassung des Füllstands vom Ultraschallsensor Ultraschallwellen ausgegeben und auf Grundlage der an der Öloberfläche reflektierten Schallwellen und deren Laufzeit der Füllstand ermittelt. Hierzu weist ein Ultraschallsensor einen Ultraschallsender und -empfänger auf.

Die Elektronik des Ultraschallwandlers, die beispielsweise ein Piezo-Element und einen integrierten Schaltkreis, beispielsweise einen ASIC, umfasst, wird nach dem elektrischen Verbinden üblicherweise in einem hohlen Gehäuse angeordnet und dort ortsfest fixiert, beispielsweise mittels eines Klebers. In alternativen Ausgestaltungen ist es bekannt, dass diese Elektronik mittels einer geeigneten Einrichtung anderweitig ortsfest innerhalb des Gehäuses platziert wird, beispielsweise durch Klipsen.

Zudem ist aus der DE 10 2012 014 307 A1 ein Verfahren und eine Sensorvorrichtung zur Erfassung eines Flüssigkeitsstands für ein Fahrzeug bekannt. Die darin offenbarte Sensoreinrichtung umfasst einen Flüssigkeitsstandsensor und einen Lagesensor. Der Flüssigkeitsstandsensor und der Lagesensor sind derart in der Sensoreinrichtung angeordnet, dass der Flüssigkeitsstandsensor und der Lagesensor eine definierte räumliche Beziehung aufweisen, sodass eine von dem Lagesensor erfasste Lage auch die Lage des Flüssigkeitsstandsensors bestimmt. Die Sensoreinrichtung ist ausgestaltet, um bei dem Erfassen des Flüssigkeitsstands die räumliche Beziehung zu berücksichtigen.

Aus der US 2016/0041024 A1 ist ein Ultraschallsensor bekannt, der an eine Tankwand gekoppelt werden kann.

Aufgabe der vorliegenden Erfindung ist es, einen hinsichtlich Herstellungskosten und Messqualität verbesserten Sensor bereitzustellen, der außerdem bezüglich der Lebensdauer robust ist.

Diese Aufgabe wird mit einem Verfahren zum Herstellen eines Ultraschallsensors gemäß Anspruch 1 und einem Ultraschallsensor gemäß Anspruch 5 gelöst. Bevorzugte Ausgestaltungen sind in den Unteransprüchen angegeben.

Der vorliegenden Erfindung liegt der Gedanke zugrunde, eine Elektronik des Ultraschallsensors in einer Spritzgussform anzuordnen und derart zu Umspritzen, dass ein Gehäuse für die Elektronik gebildet wird, wobei während des Spritzgussprozesses an dem Gehäuse weitere Funktionsabschnitte integral gebildet werden können. Zu diesen Funktionsabschnitten zählen beispielsweise Aufnahmenuten für Dichtungen, Vorsprünge zum Anbringen von externen Elementen und weitere Ausnehmungen zum Aufnehmen von externen Elementen, wie beispielsweise Sensoren. Gemäß einem ersten Aspekt ist folglich ein Verfahren zum Herstellen eines Ultraschallsensors offenbart, der dazu ausgebildet ist, den Füllstand eines in einer Brennkraftmaschine verwendeten Fluides zu erfassen. Das erfindungsgemäße Verfahren weist ein Bereitstellen einer Elektronik des Ultraschallsensors, ein Anordnen der Elektronik des Ultraschallsensors in einem Spitzgusswerkzeug und ein Umspritzen der Elektronik mit Kunststoff zum Formen eines Gehäuses für die Elektronik auf, wobei das Gehäuse zumindest einen Funktionsabschnitt aufweist, der dazu ausgebildet ist, eine vorbestimmte Funktion zu erfüllen. Der zumindest eine Funktionsabschnitt weist zumindest einen als Vorsprung ausgebildeten Befestigungsbereich auf, an dem ein Schallführungsrohr befestigbar ist. Alternativ oder zusätzlich zum Befestigungsbereich weist der zumindest eine Funktionsabschnitt eine an einer Außenseite des Gehäuses angeordnete Dichtungsausnehmung auf, die dazu ausgebildet ist, zumindest eine Dichtung aufzunehmen.

Die vorbestimmte Funktion ist dabei bevorzugt eine Funktion, die der Funktion des Ultraschallsensors nicht direkt zugeordnet ist. Das heißt, dass die vorbestimmte Funktion z. B. nicht dem Senden und Empfangen der Ultraschallwellen und/oder dem elektrischen Verbinden des Sensors zugeordnet ist.

In einer bevorzugten Ausgestaltung wird die Elektronik mit einem duroplastischen oder thermoplastischen Kunststoff umspritzt. Insbesondere ist der Kunststoff dazu ausgebildet, den Bedingungen in der Umgebung, in der der Ultraschallsensor eingesetzt wird, standzuhalten. Beispielweise ist der Kunststoff derart gewählt, dass dieser gegenüber Motoröl oder einer Harnstofflösung für SCR-Katalysatoren beständig ist. Außerdem ist der Kunststoff derart beschaffen, dass bei einer Umspritzung der Elektronik keinerlei Beschädigungen derselben auftreten.

Insbesondere ist die Dichtungsausnehmung eine umlaufende Nut, in der
eine Dichtung eingesetzt ist. Diese Dichtung kann dazu ausgebildet sein, nach dem Anordnen des Ultraschallsensors innerhalb eines Fluidbehälters (z. B. einer Ölwanne oder einem Harnstofftank) der Brennkraftmaschine eine Dichtung zum Fluidbehälter herzustellen, damit kein Fluid aus dem Behälter austreten kann.

Alternativ oder zusätzlich weist der zumindest eine Funktionsabschnitt eine Sensorausnehmung auf, in der ein Sensor eingesetzt werden kann. Beispielsweise ist die Sensorausnehmung eine im Wesentlichen zylindrische Ausnehmung, in der zum Beispiel ein Temperatursensor zum Erfassen der Temperatur des Fluides angeordnet werden kann.

Der Befestigungsbereich ist in der Form von zumindest einem Vorsprung gebildet, an dem z. B. ein Schallführungsrohr befestigt werden kann, beispielsweise mittels Ankleben, Anschweißen und/oder mittels Heißumformung bzw. -verstemmung eines aus Thermoplast gebildeten Schallführungsrohrs. In einer weiteren Ausführungsform können die separaten Elemente auch mittels einer mechanischen Verbindung lösbar am Befestigungsbereich angebracht werden, beispielsweise mittels Klipsen.

Die Elektronik des Ultraschallsensors weist vorzugsweise ein Piezo-Element auf, das an einem Trägerelement angebracht ist. Die Elektronik weist ferner einen integrierten Schaltkreis (z. B. einen sogenannten ASIC) auf, der an dem Trägerelement angebracht ist und mittels auf dem Trägerelement angeordneten Leiterbahnen mit dem Piezo-Element elektrisch verbunden ist. Das Trägerelement ist beispielsweise eine Leiterplatte (printed circuit board), ein keramisches Substrat, ein metallischer Leadframe. Die Elektronik kann ferner weitere zusätzliche elektronische Komponenten, wie beispielsweise aktive und passive Komponenten der Sensorelektronik, aufweisen, insbesondere Relais, Dioden, Kondensatoren und weitere aus dem Stand der Technik bekannte elektronische Bauteile.

Nach dem Fertigstellen der gesamten Elektronik wird diese in der Spritzgussform angeordnet und mittels des Spritzgussverfahrens derart umspritzt, dass das Gehäuse samt dem zumindest einen Funktionsabschnitt geformt wird.

Gemäß einem weiteren Aspekt der vorliegenden Erfindung ist ein Ultraschallsensor zum Erfassen des Füllstands eines Fluides in einer Brennkraftmaschine offenbart. Der erfindungsgemäße Ultraschallsensor weist eine Elektronik und ein die Elektronik umgebendes und aus Kunststoff geformtes Gehäuse auf, das mittels eines Spritzgussverfahrens hergestellt ist. Das Gehäuse umfasst zumindest einen Funktionsabschnitt, der dazu ausgebildet ist, eine vorbestimmte Funktion zu erfüllen. Die vorbestimmte Funktion ist eine Funktion, die den Funktionen des Ultraschallsensors nicht direkt zugeordnet ist. Der zumindest eine Funktionsabschnitt weist zumindest einen als Vorsprung ausgebildeten Befestigungsbereich, an dem ein Schallführungsrohr befestigbar ist, und/oder eine Dichtungsausnehmung auf, die an einer Außenseite des Gehäuses angeordnet und dazu ausgebildet ist, zumindest eine Dichtung aufzunehmen.

Der erfindungsgemäße Ultraschallsensor kann beispielsweise in einer Ölwanne der Brennkraftmaschine angeordnet werden, um den Ölstand und/oder die Öltemperatur zu erfassen. Alternativ kann der erfindungsgemäße Ultraschallwandler in einem Harnstofftank der Brennkraftmaschine eingesetzt werden, um den Füllstand und/oder die Temperatur der für einen SCR-Katalysator vorgehaltenen Harnstofflösung zu erfassen.

Weitere Merkmale und Aufgaben der Erfindung werden durch Betrachten der beiliegenden Zeichnungen ersichtlich, in denen:
- Fig. 1: eine Elektronik eines Ultraschallsensors zeigt;
- Fig. 2: eine Schnittansicht durch einen mittels dem erfindungsgemäßen Verfahren hergestellten Ultraschallsensor zeigt; und
- Fig. 3: den Ultraschallsensor der Fig. 2 in einem in einer Ölwanne eingebauten Zustand zeigt.

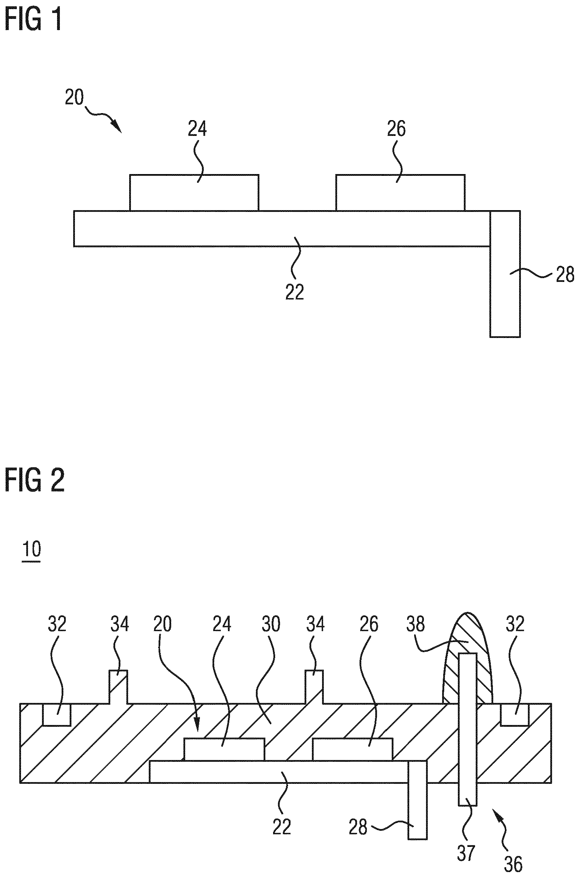

Die Fig. 1 zeigt eine schematische Ansicht einer beispielhaften Elektronik 20 eines Ultraschallsensors 10 (siehe Fig. 2). Die Elektronik 20 weist ein Trägerelement 22 auf, das in dem in den Zeichnungen dargestellten Beispiel ein keramischen Substratkörper ist und an dem ein Piezo-Element 24 als Ultraschallgeber und -empfänger und ein integrierter Schaltkreis 25, beispielsweise ein ASIC, angebracht sind. Das Piezo-Element 24 ist mit dem integrierten Schaltkreis 26 mittels zumindest einer auf dem keramischen Substratkörper angebrachten Leiterbahn (in den Zeichnungen nicht explizit dargestellt) elektrisch verbunden. An dem keramischen Substratkörper 22 ist ferner ein elektrischer Verbindungsleiter 28 vorgesehen, der dazu ausgebildet ist, dem Piezo-Element 24 und dem integrierten Schaltkreis 26 elektrische Energie zuzuführen und Signale derselben an z. B. eine Motorsteuerung zu leiten. Auf dem keramischen Substratkörper 22 können weitere elektronische Komponenten (nicht explizit dargestellt) angeordnet sein, wie beispielsweise Dioden, Kondensatoren, elektrische Leiter, Relais und weitere elektronische Bauteile.

Zur Herstellung des Ultraschallwandlers 10 kann die Elektronik 20 der Fig. 1 in einer Spritzgussform (nicht explizit dargestellt) in einer vorbestimmten Position angeordnet und mittels eines Spritzgussprozess mit einem Kunststoff zum Formen eines Gehäuses 30 (siehe Fig. 2) ummantelt werden.

Die Fig. 2 zeigt eine schematische Schnittansicht durch einen erfindungsgemäßen Ultraschallsensor 10. Wie gezeigt ist die Elektronik 20 bereits mit einem Kunststoffspritzguss umspritzt und somit innerhalb eines Gehäuses 30 angeordnet. Das Gehäuse 30 weist mehrere Funktionsabschnitte 32, 34 und 36 auf, die dazu ausgebildet sind, vorbestimmte Funktionen zu erfüllen, die der Funktion des Ultraschallsensors nicht direkt zugeordnet sind. Diese vorbestimmten Funkionen sind beispielsweise die Aufnahme einer Dichtung (nicht explizit dargestellt), das Befestigen von weiteren externen Elementen, wie beispielsweise einem Schallführungsrohr, oder die Aufnahme von weiteren externen Elementen, wie beispielsweise einem Temperatursensor.

Wie in der Fig. 2 dargestellt, weist der zumindest eine Funktionsabschnitt eine Dichtungsausnehmung 32 auf, die im Gehäuse 30 als umlaufende Nut ausgebildet ist. Die Dichtungsausnehmung 32 ist dazu ausgebildet, eine Dichtung (nicht gezeigt) aufzunehmen. Die in die Dichtungsausnehmung 32 eingesetzte Dichtung ist dazu ausgebildet, eine Dichtung zwischen dem Gehäuse und beispielsweise der Ölwanne auszubilden, wenn sich der Ultraschallsensor 10 in einem eingebauten Zustand innerhalb der Ölwanne befindet.

Der zumindest eine Funktionsabschnitt kann ferner zumindest einen Befestigungsbereich 34 aufweisen, der gemäß der Ausgestaltung der Fig. 2 in der Form von zwei Vorsprüngen gebildet ist. An diesem Befestigungsbereich 34 kann beispielsweise ein Schallführungsrohr befestigt werden, insbesondere mittels Kleben, Schweißen, Klipsen und/oder Heißverstemmen.

Ferner kann das Gehäuse 30 derart ausgebildet sein, dass der Funktionsabschnitt eine Sensorausnehmung 36 aufweist, in der beispielsweise ein Temperatursensor 37 zum Erfassen der Temperatur des Motoröls angeordnet werden kann. Hierzu kann das Gehäuse 30 ferner einen Vorsprung 38 aufweisen, in den die Sensorausnehmung 36 zumindest teilweise hineinragt (siehe Fig. 2) .

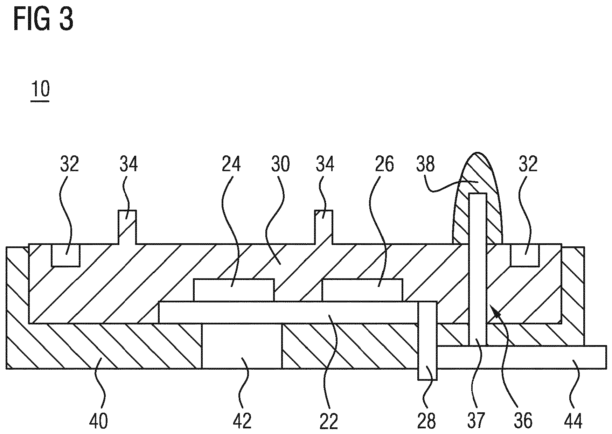

Unter Verweis auf die Fig. 3 ist der Ultraschallsensor 10 der Fig. 2 in einem teilweise eingebauten Zustand gezeigt. Der Fig. 3 ist zu entnehmen, dass der Ultraschallsensor 10 an einer Halterung 40 befestigt ist, die wiederum innerhalb einer Ölwanne angeordnet und an der Ölwanne befestigt werden kann. Die Halterung 40 weist ein Dämpfungselement 42 auf, das dazu ausgebildet ist, die Schwingungen des Piezo-Elements 24 mechanisch zu dämpfen. Dies kann die Messgenauigkeit und den Messbereich des Ultraschallsensors 10 verbessern.

An der Halterung 40 befindet sich ferner ein weiterer elektrischer Verbindungsleiter 44, der mit dem Verbindungsleiter 28 der Elektronik 20 elektrisch verbunden und dazu ausgebildet ist, Stromsignale und Sensorsignale zwischen der Elektronik 20 und einer Motorsteuerung (nicht explizit dargestellt) zu vermitteln.

## Patentansprüche

1. Verfahren zum Herstellen eines Ultraschallsensors (10), der dazu ausgebildet ist, den Füllstand eines Fluides in einer Brennkraftmaschine zu erfassen, wobei das Verfahren aufweist:
- Bereitstellen einer Elektronik (20) des Ultraschallsensors (10),
- Anordnen der Elektronik (20) des Ultraschallsensors (10) in einem Spitzgusswerkzeug,
- Umspritzen der Elektronik (20) mittels Spritzgussverfahrens mit Kunststoff zum Formen eines Gehäuses (30) für die Elektronik (20) derart, dass das Gehäuse (30) zumindest einen Funktionsabschnitt (32, 34, 36) aufweist, der dazu ausgebildet ist, eine vorbestimmte Funktion zu erfüllen,
**dadurch gekennzeichnet, dass**
der zumindest eine Funktionsabschnitt zumindest einen als Vorsprung ausgebildeten Befestigungsbereich (34), an dem ein Schallführungsrohr befestigbar ist, und/oder eine Dichtungsausnehmung (32) aufweist, die an einer Außenseite des Gehäuses (30) angeordnet und dazu ausgebildet ist, zumindest eine Dichtung aufzunehmen.

2. Verfahren nach Anspruch 1, wobei der Kunststoff ein duroplastischer oder ein thermoplastischer Kunststoff ist, der gegenüber dem Fluid beständig ist.

3. Verfahren nach einem der vorhergehenden Ansprüche, wobei der zumindest eine Funktionsabschnitt eine Sensorausnehmung (36) aufweist, in der ein Sensor (37) einsetzbar ist.

4. Verfahren nach einem der vorhergehenden Ansprüche, wobei das Bereitstellen der Elektronik (20) des Ultraschallsensors (10) umfasst:
- Bereitstellen eines Trägerelements (22),
- Anbringen von zumindest einem Piezo-Element (24) an dem Trägerelement (22),
- Anbringen eines integrierten Schaltkreises (26) an dem Trägerelement (22), und
- elektrisches Verbinden des Piezo-Elements (24) und des integrierten Schaltkreises (26) mit auf dem Trägerelement (22) angeordneten Leitern.

5. Ultraschallsensor (10) zum Erfassen des Füllstands eines Fluides in einer Brennkraftmaschine, wobei der Ultraschallsensor (10) aufweist:
- eine Elektronik (20) und
- ein um die Elektronik (20) mittels Spritzgussverfahrens hergestelltes und aus Kunststoff geformtes Gehäuse (30), das zumindest einen Funktionsabschnitt (32, 34, 36) aufweist, der dazu ausgebildet ist, eine vorbestimmte Funktion zu erfüllen,
**dadurch gekennzeichnet, dass**
der zumindest eine Funktionsabschnitt zumindest einen als Vorsprung ausgebildeten Befestigungsbereich (34), an dem ein Schallführungsrohr befestigbar ist, und/oder eine Dichtungsausnehmung (32) aufweist, die an einer Außenseite des Gehäuses (30) angeordnet und dazu ausgebildet ist, zumindest eine Dichtung aufzunehmen.

6. Ultraschallsensor (10) nach Anspruch 5, wobei der Kunststoff ein duroplastischer oder ein thermoplastischer Kunststoff ist, der gegenüber dem Fluid beständig ist.

7. Ultraschallsensor (10) nach einem der Ansprüche 5 und 6, wobei der zumindest eine Funktionsabschnitt eine Sensorausnehmung (36) aufweist, in der ein Sensor (37) einsetzbar ist.

## Claims

1. Method for producing an ultrasound sensor (10) which is designed to detect the filling level of a fluid in an internal combustion engine, wherein the method comprises:
- providing an electronics system (20) of the ultrasound sensor (10),
- arranging the electronics system (20) of the ultrasound sensor (10) in an injection moulding die,
- encapsulating the electronics system (20) by injection moulding with plastic by means of an injection moulding process for the purpose of forming a housing (30) for the electronics system (20) in such a way that the housing (30) has at least one functional section (32, 34, 36) which is designed to fulfil a predetermined function,
**characterized in that**
the at least one functional section has at least one fastening region (34) which is designed as a projection and to which a sound carrying tube can be fastened, and/or has a seal recess (32) which is arranged on an outer side of the housing (30) and is designed to receive at least one seal.

2. Method according to Claim 1, wherein the plastic is a thermosetting or a thermoplastic material which is resistant to the fluid.

3. Method according to either of the preceding claims, wherein the at least one functional section has a sensor recess (36) in which a sensor (37) can be inserted.

4. Method according to one of the preceding claims, wherein providing the electronics system (20) of the ultrasound sensor (10) comprises:
- providing a carrier element (22),
- fitting at least one piezo element (24) to the carrier element (22),
- fitting an integrated circuit (26) to the carrier element (22), and
- electrically connecting the piezo element (24) and the integrated circuit (26) to conductors which are arranged on the carrier element (22).

5. Ultrasound sensor (10) for detecting the filling level of a fluid in an internal combustion engine, wherein the ultrasound sensor (10) has:
- an electronics system (20) and
- a housing (30) which is produced around the electronics system (20) by means of an injection moulding process and is formed from plastic and has at least one functional section (32, 34, 36) which is designed to fulfil a predetermined function,
**characterized in that**
the at least one functional section has at least one fastening region (34) which is designed as a projection and to which a sound carrying tube can be fastened, and/or has a seal recess (32) which is arranged on an outer side of the housing (30) and is designed to receive at least one seal.

6. Ultrasound sensor (10) according to Claim 5, wherein the plastic is a thermosetting or a thermoplastic material which is resistant to the fluid.

7. Ultrasound sensor (10) according to either of Claims 5 and 6, wherein the at least one functional section has a sensor recess (36) in which a sensor (37) can be inserted.

## Revendications

1. Procédé de fabrication d'un capteur à ultrasons (10), lequel est configuré pour détecter le niveau d'un fluide dans un moteur à combustion interne, le procédé comprenant :
- la fourniture d'une électronique (20) du capteur à ultrasons (10),
- la disposition de l'électronique (20) du capteur à ultrasons (10) dans un outil de moulage par injection,
- le surmoulage par injection de l'électronique (20) au moyen d'un procédé de moulage par injection avec une matière plastique en vue de former un boîtier (30) pour l'électronique (20) de telle sorte que le boîtier (30) possède au moins une portion fonctionnelle (32, 34, 36) qui est configurée pour remplir une fonction prédéterminée,
**caractérisé en ce que**
l'au moins une portion fonctionnelle possède au moins une zone de fixation (34) réalisée sous la forme d'une partie saillante, à laquelle peut être fixé un tube de guidage acoustique, et/ou un creux de garniture d'étanchéité (32), qui est disposé au niveau d'un côté extérieur du boîtier (30) et est configuré pour accueillir au moins une garniture d'étanchéité.

2. Procédé selon la revendication 1, la matière plastique étant une matière plastique thermodurcissable ou un thermoplastique, qui est résistant(e) au fluide.

3. Procédé selon l'une des revendications précédentes, l'au moins une portion fonctionnelle possédant un creux de capteur (36) dans lequel peut être inséré un capteur (37).

4. Procédé selon l'une des revendications précédentes, la fourniture de l'électronique (20) du capteur à ultrasons (10) comprenant :
- la fourniture d'un élément porteur (22),
- la mise en place d'au moins un élément piézoélectrique (24) sur l'élément porteur (22),
- la mise en place d'un circuit intégré (26) sur l'élément porteur (22), et
- la connexion électrique de l'élément piézoélectrique (24) et du circuit intégré (26) avec des conducteurs disposés sur l'élément porteur (22).

5. Capteur à ultrasons (10) destiné à détecter le niveau d'un fluide dans un moteur à combustion interne, le capteur à ultrasons (10) comprenant :
- une électronique (20) et
- un boîtier (30) fabriqué autour de l'électronique (20) au moyen d'un procédé de moulage par injection et formé de matière plastique, lequel possède au moins une portion fonctionnelle (32, 34, 36) qui est configurée pour remplir une fonction prédéterminée,
**caractérisé en ce que**
l'au moins une portion fonctionnelle possède au moins une zone de fixation (34) réalisée sous la forme d'une partie saillante, à laquelle peut être fixé un tube de guidage acoustique, et/ou un creux de garniture d'étanchéité (32), qui est disposé au niveau d'un côté extérieur du boîtier (30) et est configuré pour accueillir au moins une garniture d'étanchéité.

6. Capteur à ultrasons (10) selon la revendication 5, la matière plastique étant une matière plastique thermodurcissable ou un thermoplastique, qui est résistant(e) au fluide.

7. Capteur à ultrasons (10) selon l'une des revendications 5 et 6, l'au moins une portion fonctionnelle possédant un creux de capteur (36) dans lequel peut être inséré un capteur (37).
